# EUROPEAN PATENT SPECIFICATION

(11) **EP 1 717 665 B1**
(45) Date of publication and mention of the grant of the patent: **09.06.2010**
(21) Application number: 05425277.0
(22) Date of filing: 29.04.2005
(51) Int. Cl.: G06F 1/30, G06F 1/32, G06F 11/14, G06F 9/312, G06F 9/355, G06F 12/02

(54) **Transaction stack for electronic devices including non volatile memory with limited amount of writing cycles**
Transaktionstapel für elektronische Geräte mit einem nichtflüchtigen Speicher, der eine begrenzte Anzahl von Schreibzyklen aufweist
Pile de transaction pour appareils électroniques comprenant une mémoire non volatile à nombre de cycles d'écriture limités

(43) Date of publication of application: 02.11.2006
(73) Proprietor: Incard SA, 1204 Geneva (CH)
(72) Inventor: Concilio, Mariano, 84018 Scafati (IT)
(74) Representative: Botti, Mario

(56) References cited:
- EP-A- 0 964 360
- US-A1- 2005 055 498
- STRASS H: "UNAUFFAELLIGE BREUCKENBAUER" ELEKTRONIK, WEKA FACHZEITSCHRIFTENVERLAG, POING, DE, vol. 43, no. 22, 31 October 1994 (1994-10-31), pages 146-150, XP000474171 ISSN: 0013-5658

## Description

### Field of Application

The present invention relates to a transaction stack for electronic devices including non volatile memory with limited writing cycle.

In particular the invention relates to devices of the above type and comprising a method for storing non volatile data during secure transactions, being said non volatile data files, passwords, cryptographic keys, certificates, user profiles, as well as operative system status variables, application status variables, the application registry, executable applications and so on.

### Background of the Invention

As it is well known an embedded device like an IC-Card uses a solid-state semiconductor memory portion to store non volatile data.

The category of non volatile data includes application executables, files, passwords, cryptographic keys, certificates, user profiles, as well as operative system status variables, application status variables, the application registry and so on. The content of all the above data is variable during the operative phase of the device but they shall preserve their value during the power off.

On the contrary, the value of volatile data is lost during a power off phase and is initialized at the device start-up. The category of volatile data includes the CPU stack, buffers for I/O operations, buffers for temporary computations and so on.

The non volatile memory assures that the value of non volatile data is not lost following a regular switch-off of the device, i.e. when the electrical deactivation occurs in an idle state of the device. This is the typical case, when the deactivation is driven by the logic of the terminal which the device is connected to.

On the other hand, if an accidental electrical deactivation occurs during an application execution, specifically during an updating operation of complex non volatile data, it's possible that the value of data is left in an inconsistent state, that could compromise, completely or partially, the functioning or the security of the device in the successive power-on sessions.

To face this problem, the operating systems provide the known mechanism of transaction.

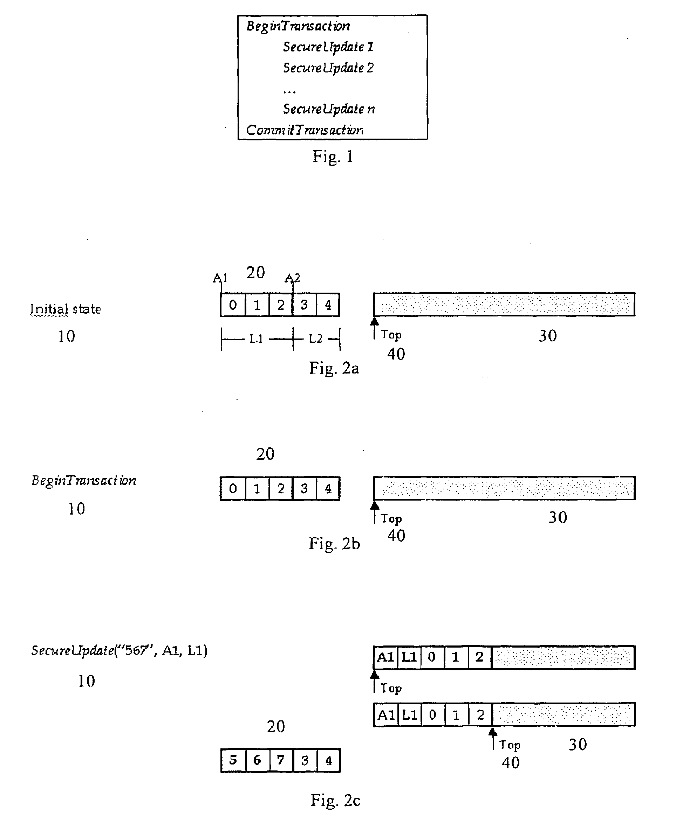

The transaction mechanism provides to application layer the instruments to group together an arbitrary number of writing operations, establishing that they have to be considered as a single atomic writing operation respect to events like a power off. The application has to mark all the writing operations between two instructions. We can say, in a simple pseudo-language, that all the write operations must be included between two instructions, namely BeginTransaction and CommitTransaction, as schematically shown in Figure 1.

In case of power off during the execution of the code included between said two instructions BeginTransaction and CommitTransaction, the operative system assures that the value of all the non volatile data affected by the "Secure Updates" are restored, at next device start-up, to the value they had before the statement BeginTransaction.

Advanced implementations allow multilevel transactions, with nested levels of BeginTransaction and CommitTransaction instructions.

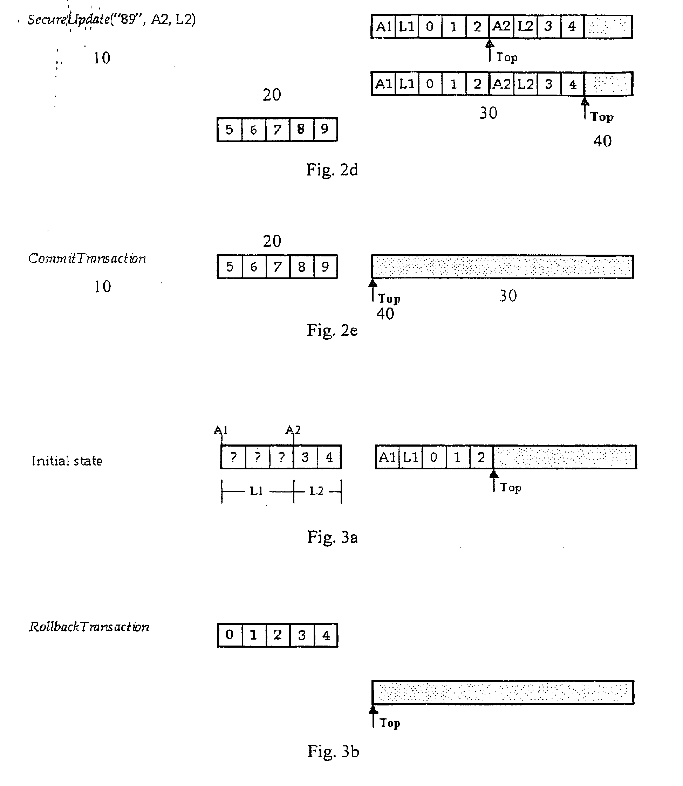

The transaction mechanism can be implemented by using a transaction stack, as will be clear by the following description, supported by Figure 2.

In this Figure the possible states of execution of a transaction, comprising two Secure Operations, are indicated with 10. In particular in Figure 2a the transaction is in an "Initial state" state, in Figure 2b it is in a "Begin Transaction" state, in Figure 2c in a "Secure Update" state, in 2d it is still in the "Secure Update" state and, finally, in 2e it is in a "Commit Transaction" state.

In Figure 2 the non volatile memory is also schematically shown and indicated with numeral reference 20; its values, during all the possible states of transaction execution, are indicated inside the cells of the non volatile memory 20. In particular the start address of the non volatile memory 20 in which data will be written by the first secure operation, is indicated with A1 and the length of data to be written during the first secure operation with L1.

Similarly the start address of non volatile memory 20 in witch data will be written by the second secure operation is indicated with A2 and the length of data to be written during the second secure operation is indicated with L2. Finally the transaction stack is indicated with 30, and Top pointer to the transaction stack with 40.

The transaction stack 30 is cleaned at the invocation of BeginTransaction when the transaction is in the "Initial state". Each Secure Updating operation, as shown in Figures 2c and 2d, adds a record on the transaction stack 30, containing the information to recover the original value of that data after a potential unexpected power off (typically: the data address / size / value). At the invocation of CommitTransaction the transaction stack 30 is cleaned again.

The Figure 3 shows the recovery, at the device start-up, of the original data values in case of device power off during the first Secure Update operation. In particular in Figure 3a is schematically shown the device start-up after an incorrect power off that caused the loosing of some data inside the non volatile memory 20, indicating lost data with the symbol "???".

In Figure 3b a Rollback transaction restores the lost data inside their original position, recovering the right values from the transaction stack 30.

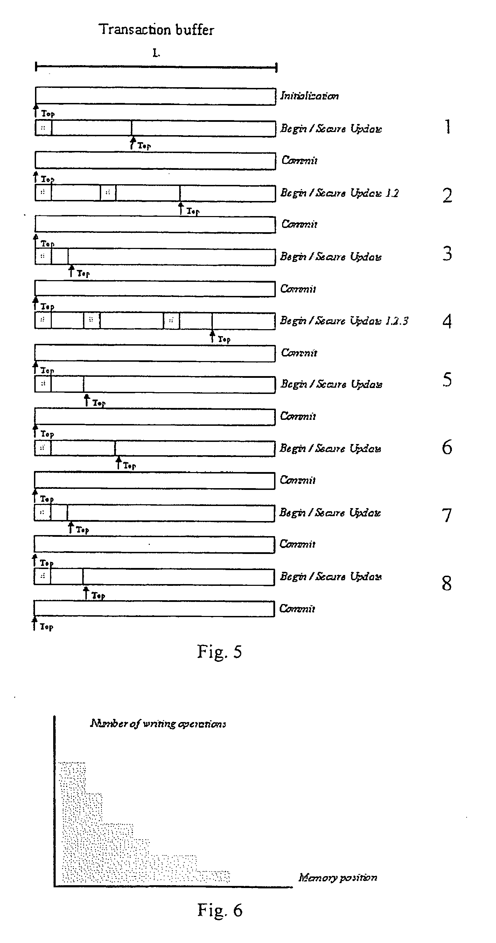

The Figure 5 instead gives an example of the transaction stack 30 usage in case of eight consecutive transactions, containing a different number of Secure Updating operations. The transactions indicated with numbers 1, 3, 5, 6, 7 8 contain just one update, the transaction number 2 contains 2 updates and the transaction number 4 contains 3 updates. Figure 6 displays a graphic showing the total number of writing operations following the eight transactions schematically shown in figure 5.

If the device deactivation is regular, there is no application execution ongoing than, at the device start-up, the transaction stack 30 is always empty. On the other hand, if the device is deactivated while an application is working and the execution flow is between the two instructions BeginTransaction and CommitTransaction, then the operating system, at the next start-up, finds the transaction stack 30 NOT empty and carries out all the recovery operations according the records on the transaction stack 30. After that, the stack is cleaned.

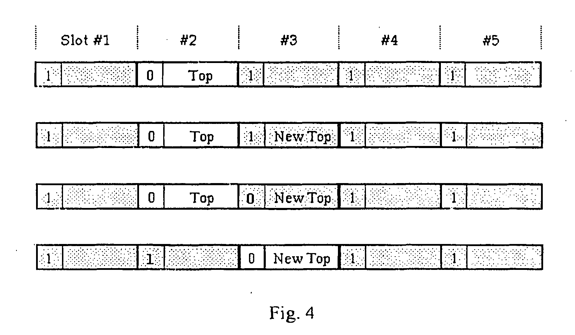

Note that the implementation of the transaction stack 30 needs a non volatile variable to store the pointer to the top of the transaction stack 30 (Top in the following). Of course, the value of Top is itself a sensible data respect to an accidental power-off event. So, a dedicated mechanism, independent from the transaction stack, is required to assure the "atomicity" of the Top variable. This is typically obtained by a dedicated pointer-less circular buffer. This solution is feasible because the Top variable is a single, short and predefined-size data (2 or 4 bytes). The Figure 4 shows an example of an atomic updating mechanism for the Top pointer, by means of a 5-slot pointer-less circular buffer. Each slot is tagged with a binary flag ('0' or '1'). In each time, the current value of Top is contained in the first slot tagged with '0', from left to right.

At the state of the art, the non volatile memory 20 allows a limited number of writing accesses. Over this limit, the "data retention time" of the non volatile memory 20 decreases to values not acceptable for any applicative purpose. For example, the number of the allowed writing operations for EEPROM or Flash memories is typically in the range of 100.000 to 1.000.000, independently on each memory cell.

This limitation has an heavy impact on the standard implementation of the transaction mechanism, as any secure writing operation performed by the applications has the side effect of a further writing operation in the transaction stack 30. Particularly, the first secure writing operation of any transaction (the instructions SecureUpdate 1 in the Figure 5) causes a writing access to the first byte of the transaction stack 30. So, the maximum number of writing accesses to this byte bounds the number of the secure updating operations allowed to the applications, irrespective where the applications write. Even if the device is guaranteed for 100.000 writing operations on each single byte of the non volatile memory 20, the applications can't perform more than 100.000 secure updating, even on different non volatile memory areas, because in opposite case, the first bytes of the transaction stack 30 could be damaged.

A solution to this limitation could be an implementation of the transactions stack 30 in a circular buffer, where all the bytes are stressed in the same way. Nevertheless, a circular implementation is much more difficult of a linear one because of the nature of the transaction mechanism: each transaction include one or more records, with different lengths and nested in case of nested transactions. Moreover, the reuse of the implementation of a linear stack for a circular stack is rather hard.

US 2005/055498 A1 (BECKERT RICHARD DENNIS ET AL) 10 March 2005 (2005-03-10) discloses a method for maintaining system's critical data in an electronic device by writing said critical data in a non volatile memory portion. It discloses the problem of wear levelling, said non volatile memory portion having limited writing cycle. The wear levelling problem is solved by tracking the current free block and the offset of the last written page and by writing the next page to a block at a physical address always greater than the address of the previous page write.

The problem at the basis of the present invention is that of designing an electronic device including non volatile memory having a transaction stack able to stress not only the first bytes, during the writing operations on transaction stack.

### Summary of the invention

The invention is set out in claims 1 and 8.

The solution idea on which the invention is based is that of providing a transaction stack 2 of the type described characterized by the fact that all the bytes belonging to the transaction buffer 2 are used as long as possible.

On the basis of this solution idea the technical problem is solved according to the present invention by a method as previously indicated and characterised by the fact that said transaction stack 2 is sliding dynamically inside a transaction buffer 1, the transaction stack 2 having a size minor than the size of said transaction buffer 1 .

Further characteristics and the advantages of the sliding transaction stack 2 and of the writing non volatile memory method according to the present invention will be apparent from the following description of an embodiment thereof, made with reference to the annexed drawings, given for indicative and non-limiting purpose.

### Brief Description of the drawing

- Figure 1 describes in a high level language the execution of Secure operations based on BeginTransaction - Commit Transaction method, according to prior art.
- Figures 2a, 2b, 2c, 2d, 2e are schematic representations of the execution of a transaction operations respectively in "Initial", "Begin Transaction", "Secure Update", "Secure Update", "Commit Transaction" state, according to prior art.
- Figures 3a and 3b are schematic representations of a rollback of non volatile data original values, respectively in "Initial" and "Rollback transaction" state, according to prior art.
- Figure 4 is a schematic representation of an atomic update of the Top pointer by means of a pointer-less buffer, according to prior art.
- Figure 5 is a schematic representation of several transactions of secure operations, according to standard implementation.
- Figure 6 is a diagram representing the writing operations along the transaction stack according to transactions of Figure 5 and prior art.
- Figure 7 is a schematic representation of several transactions of secure operations, according to the present invention.
- Figure 8 is a diagram representing the writing operations along the transaction buffer according to transactions of Figure 7.

### Detailed Description

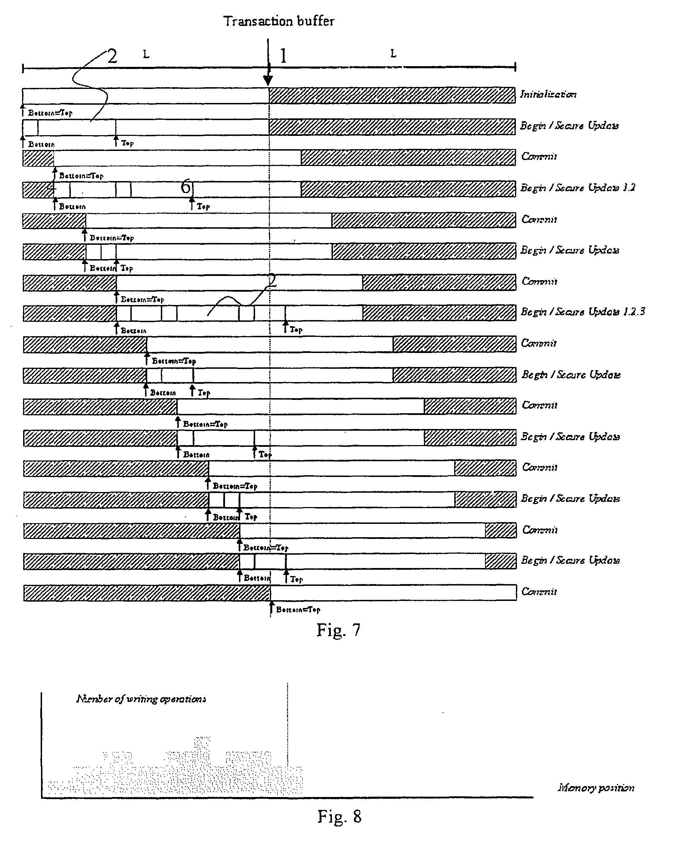

Having a reference to the drawings of Figure 7 a transaction buffer realized according to the present invention is globally and schematically shown with the numeral reference 1.In the same Figure a transaction stack is indicated with 2. On the basis of the present invention the technical problem is solved by a method as previously indicated and characterised by the fact that said transaction stack 2 is sliding dynamically inside said transaction buffer 1. This sliding effect is obtained by resetting the start address bottom 4 of said transaction stack 2 to a new position inside the transaction buffer 1, after the execution of said secure transaction.

The bottom pointer 4 moves along said transaction buffer 1 after a beginning transaction of said secure transaction, by resetting its address in a predetermined location included between the start address of said transaction buffer 1 and the location obtained by adding, to said start address, the difference between the lengths of said transaction buffer 1 and said transaction stack 2.

The bottom pointer 4 is set in a specific position during the initialization phase of said device 5, according to a predetermined location rule.

Alternatively the bottom pointer 4 moves along said transaction buffer 1 after a beginning transaction of said secure transaction, by resetting its address in a random location included between the start address of said transaction buffer 1 and the location obtained by adding, to said start address, the difference between the lengths of said transaction buffer 1 and said transaction stack 2.

The transaction stack 2 moves cyclically along said transaction buffer 1 by means of setting said bottom pointer 4 in different positions along the transaction buffer 1 after each beginning transaction and by resetting said bottom pointer 4 at the beginning of said transaction buffer 1 ciclycally.

In Figure 7, the start position of the transaction stack 2 inside the transaction buffer 1 is indicated by a bottom pointer 4.

In figure 7, the bottom pointer 4 is set, during start up phase of the device, at the start of transaction buffer 1 so that the remaining part of transaction buffer 1 is not used for writing operation.

In other word, if we indicate the start position of transaction buffer 1 with the co-ordinate 0 and the end position with the co-ordinate 2L, we can refer to the starting and end position of the transaction buffer 2 with coordinate 0 and L respectively.

When a secure update occurs, the transaction stack 2 is written to store values of non volatile memory to be updated; in particular the first memory cells of transaction stack 2 are written; in other words the cells in absolute position with co-ordinate 0, 1, 2, 3, 4, 5, 6 are written.

After the execution of the first secure update, the bottom pointer 4 shifts, for example, two memory cells through the transaction buffer 1 so that the start and end position of the transaction stack 2 changes respectively in 2 an L+2.

In other words the transaction stack 2 moves into the new free memory cells inside the transaction buffer 1, that are cells in absolute position with coordinate from 2 to L+2

When a second secure update occurs, the transaction stack 2 is once more written to store values of non volatile memory to be updated; the first memory cells of transaction stack 2, this time, start from absolute position with coordinate 2; in other words the cells in absolute position with co-ordinate 2 ,3 ,4, 5, 6, 7, 8, 9, 10, 11 are written and cells with absolute positions 0 and 1 are no more stressed during this second secure update.

According to the present invention the allocation of transaction stack 2 is obtained moving the bottom pointer 4 within the dedicated non volatile memory of transaction buffer 1. The transaction stack 2 is re-allocated in a new position of the transaction buffer 1 following any CommitTransaction or, alternatively, BeginTransaction event.

More in particular the invention can be implemented in different convenient modes. A first embodiment of the invention is based on an initialization phase of device, like an IC-card, consisting, as shown above, in setting the transaction stack 2 at the beginning of transaction buffer 1.

Following initialization phase, the operative phase and a CommitTransaction event occur. After that, the bottom pointer 4 is moved forward resetting its address in a new location included between the start address of said transaction buffer 1 and a predetermined address, Max_addr. In particular the address Max_addr is obtained by adding, to said start address of the transaction buffer 1, the difference between the lengths of said transaction buffer 1 and said transaction stack 2. When the bottom pointer 4 reaches the end of the transaction buffer 1, it's driven back to the beginning of the transaction buffer 1.

In another embodiment of the present invention an initialization phase of the IC-Card is always present. This phase consists in the setting of the position of the bottom pointer 4 in some position within the transaction buffer 1, predefined or randomly generated and included between the start address of transaction buffer 1 and Max_addr. Then an operative phase follows and, finally, the transaction stack 2 can be re-allocated in a new position following a BeginTransaction event instead of a CommitTransaction event.

The new offset of the transaction stack 2 can follow a predefined law (linear or not linear), that is a function of the previous offset.

The new offset of the transaction stack 2 can be randomly generated according a predefined distribution law (uniform or not uniform), that is a function of the position along the transaction buffer 1.

As explained, the Figure 7 shows a first embodiment of the invention, with a transaction stack 2 within a transaction buffer 1, initially set at the beginning of the transaction buffer 1 . The graphic in Figure 8 gives the distribution on the writing accesses along the transaction buffer 1 according to the example of Figure 7.

The implementation of a transaction stack 2 contained in a transaction buffer 1 requires the management of two pointers, a pointer Top 6, indicating the address of the first free location inside the transaction stack 2 for writing operations, and a pointer bottom 4, indicating the start address of the transaction stack 2 inside transaction buffer 1 wherein the transaction stack 2 will be relocated after a Commit Transaction Event. Both these data are sensible with respect the power-off event and they should be stored in a dedicated pointer-less circular buffer, as the pointer Top of the standard implementation.

During the execution of a single transaction, the behavior of the proposed transaction mechanism is the same of the standard implementation, both in terms of logic (algorithms / data structures to store the records) and in terms of efficiency (speed and number of updating operations). The only difference is that the base address of the process is not fixed but it's the address pointed by Bottom pointer 4. This allows a simple and extensive reuse of the standard implementation, with very limited and reliable upgrades.

In case of a CommitTransaction event, the cost required to locate the new position for the transaction stack 2 is just the updating of the Bottom Pointer 4 - Top pointer 6 pair to the new address. This effort is comparable with the effort to reset the Top pointer 6 in the standard implementation. The shifting of the transaction stack in the new position is very effective because the transaction stack is moved while it's empty, so no extensive data copying is required.

The advantages of the proposed mechanism respect to the standard implementation are noticeable: the writing accesses to the non volatile memory of the transaction buffer 1 are not concentrated in first bytes but they are spread over a large address range, defined by the values of the Bottom pointer 4, as underlined by the graphic of Figure 8.

Besides the implementation is based on a linear and dynamic transaction stack, allowing an easy and extensive reuse of the standard implementation that is based on fixed and linear transaction stack, considerably easier to use with respect to circular stack solutions.

## Claims

1. Method for implementing a transaction stack (2) in an electronic device including a non volatile memory portion with limited writing cycle (5), of the type comprising the storing of non volatile data during secure transactions **characterized by** providing a transaction stack (2) dynamically sliding inside a transaction buffer (1) of said non volatile memory portion after the execution of a said secure transaction, said transaction stack (2) having a size minor than the size of said transaction buffer (1), said transaction stack (2) after the execution of a said secure transaction partially overlapping the transaction stack before said execution of a said secure transaction.

2. Method according to claim 1, **characterized by** the fact that the start address bottom (4) of said transaction stack (2) is reset to a new position inside the transaction buffer (1).

3. Method according to claim 1, **characterized by** the fact that the start address bottom (4) of said transaction stack (2) is set at the beginning of said transaction buffer (1) during the initialization phase of said device (5).

4. Method according to claim 2, **characterized by** the fact that said bottom pointer (4) moves along said transaction buffer (1), after a beginning transaction of said secure transaction, by resetting its address in a predetermined location included between:
- the start address of said transaction buffer (1) and
- the location obtained by adding, to said start address, the difference between the lengths of said transaction buffer (1) and said transaction stack (2).

5. Method according to claim 3, **characterized by** the fact that said bottom pointer (4) is set in a specific position during the initialization phase of said device (5), according to a predetermined location rule.

6. Method according to claim 2, **characterized by** the fact that said bottom pointer (4) moves along said transaction buffer (1), after a beginning transaction of said secure transaction, by resetting its address in a random location included between:
- the start address of said transaction buffer (1) and
- the location obtained by adding, to said start address, the difference between the lengths of said transaction buffer (1) and said transaction stack (2).

7. Method according to claim 2 **characterized by** the fact that said transaction stack (2) moves cyclically along said transaction buffer (1) by means of setting said bottom pointer (4) in different positions along the transaction buffer (1) after each beginning transaction and by resetting said bottom pointer (4) at the beginning of said transaction buffer (1) cyclically.

8. Electronic device including a non volatile memory portion with limited writing cycle (5) and wherein non volatile data are stored during secure transactions **characterized by** a transaction stack (2) dynamically sliding inside a transaction buffer (1) of said non volatile memory portion after the execution of a said secure transaction, said transaction stack (2) having a size minor than the size of said transaction buffer (1), said transaction stack (2) after the execution of a said secure transaction partially overlapping the transaction stack before said execution of a said secure transaction.

## Patentansprüche

1. Verfahren zum Implementieren eines Transaktion-Stapelspeichers (2) in einem elektronischen Gerät mit einem nicht-flüchtigen Speicherbereich mit einer begrenzten Anzahl von Schreibzyklen (5) von der Art, dass das Verfahren das Speichern von nicht-flüchtigen Daten während sicherer Transaktionen aufweist, **gekennzeichnet durch** Bereitstellen eines Transaktion-Stapelspeichers (2), der sich innerhalb eines Transaktion-Pufferspeichers (1) des nicht-flüchtigen Speicherbereichs nach der Ausführung von einer der sicheren Transaktionen dynamisch verschiebt, wobei der Transaktion-Stapelspeicher (2) eine Größe hat, die kleiner als die Größe des Transaktion-Pufferspeichers (1) ist, und wobei der Transaktion-Stapelspeicher (2) nach der Ausführung von einer der sicheren Transaktionen potentiell mit dem Transaktion-Stapelspeicher vor der genannten Ausführung von einer der sicheren Transaktionen überlappt.

2. Verfahren nach Anspruch 1, **gekennzeichnet durch** die Tatsache, dass die Startadresse des unteren Endes (4) des Transaktion-Stapelspeichers (2) auf eine neue Position innerhalb des Transaktion-Pufferspeichers (1) umgesetzt wird.

3. Verfahren nach Anspruch 1, **gekennzeichnet durch** die Tatsache, dass die Startadresse des unteren Endes (4) des Transaktion-Stapelspeichers (2) auf den Anfang des Transaktion-Pufferspeichers (1) während der Initialisierungsphase des Geräts (5) gesetzt wird.

4. Verfahren nach Anspruch 2, **gekennzeichnet durch** die Tatsache, dass sich der Zeiger des unteren Endes (4) nach einer Anfangstransaktion der sicheren Transaktion entlang des Transaktion-Pufferspeichers (1) bewegt **durch** Umsetzen seiner Adresse auf eine vorbestimmte Position, die enthalten ist zwischen:
- der Startadresse des Transaktion-Pufferspeichers (1) und
- der Position, die **durch** Hinzufügen der Differenz zwischen der Länge des Transaktion-Pufferspeichers (1) und der Länge des Transaktion-Stapelspeichers (2) zu der Anfangsadresse erhalten wird.

5. Verfahren nach Anspruch 3, **gekennzeichnet durch** die Tatsache, dass der Zeiger des unteren Endes (4) auf eine bestimmte Position während der Initialisierungsphase des Geräts (5) gemäß einer vorbestimmten Positionsregel gesetzt wird.

6. Verfahren nach Anspruch 2, **gekennzeichnet durch** die Tatsache, dass sich der Zeiger des unteren Endes (4) nach einer Anfangstransaktion der sicheren Transaktion entlang des Transaktion-Pufferspeichers (1) bewegt **durch** Umsetzen seiner Adresse auf eine zufällige Position, die enthalten ist zwischen:
- der Startadresse des Transaktion-Pufferspeichers (1) und
- der Position, die **durch** Hinzufügen der Differenz zwischen der Länge des Transaktion-Pufferspeichers (1) und der Länge des Transaktion-Stapelspeichers (2) zu der Anfangsadresse erhalten wird.

7. Verfahren nach Anspruch 2, **gekennzeichnet durch** die Tatsache, dass sich der Transaktion-Stapelspeicher (2) zyklisch entlang des Transaktion-Pufferspeichers (1) bewegt mittels Setzen des Zeigers des unteren Endes (4) auf verschiedene Positionen entlang des Transaktion-Pufferspeichers (1) nach jeder Anfangstransaktion und **durch** zyklisches Zurücksetzen des Zeigers des unteren Endes (4) auf den Anfang des Transaktion-Pufferspeichers (1).

8. Elektronisches Gerät mit einem nicht-flüchtigen Speicherbereich mit einer begrenzten Anzahl von Speicherzyklen (5), wobei nicht-flüchtige Daten während sicherer Transaktionen gespeichert werden, **gekennzeichnet durch** einen Transaktion-Stapelspeicher (2), der sich innerhalb eines Transaktion-Puffer speichers (1) des nicht-flüchtigen Speicherbereichs nach der Ausführung von einer der sicheren Transaktionen dynamisch verschiebt, wobei der Transaktion-Stapelspeicher (2) eine Größe hat, die kleiner als die Größe des Transaktion-Pufferspeichers (1) ist, und wobei der Transaktion-Stapelspeicher (2) nach der Ausführung von einer der sicheren Transaktionen potentiell mit dem Transaktion-Stapelspeicher vor der genannten Ausführung von einer der sicheren Transaktionen überlappt.

## Revendications

1. Procédé de mise en oeuvre d'une pile de transaction (2) dans un appareil électronique comprenant une partie mémoire non volatile à cycle d'écriture limité (5), du type comprenant le stockage de données non volatiles pendant des transactions sécurisées, **caractérisé par** le fait de fournir une pile de transaction (2) qui glisse de façon dynamique à l'intérieur d'une mémoire tampon de transaction (1) de ladite partie mémoire non volatile après l'exécution d'une dite transaction sécurisée, ladite pile de transaction (2) ayant une plus petite taille que ladite mémoire tampon de transaction (1), ladite pile de transaction (2), après l'exécution d'une dite transaction sécurisée, chevauchant partiellement la pile de transaction avant ladite exécution d'une dite transaction sécurisée.

2. Procédé selon la revendication 1, **caractérisé par le fait que** la fin de l'adresse de départ (4) de ladite pile de transaction (2) est réinitialisée sur une nouvelle position à l'intérieur de la mémoire tampon de transaction (1).

3. Procédé selon la revendication 1, **caractérisé par le fait que** la fin de l'adresse de départ (4) de ladite pile de transaction (2) est placée au début de ladite mémoire tampon de transaction (1) pendant la phase d'initialisation dudit appareil (5).

4. Procédé selon la revendication 2, **caractérisé par le fait que** ledit pointeur de fin (4) se déplace le long de ladite mémoire tampon de transaction (1), après une transaction de début de ladite transaction sécurisée, en réinitialisant son adresse en un endroit prédéterminé compris entre :
- l'adresse de début de ladite mémoire tampon de transaction (1), et
- l'endroit obtenu en ajoutant à ladite adresse de début la différence entre les longueurs de ladite mémoire tampon de transaction (1) et de ladite pile de transaction (2).

5. Procédé selon la revendication 3, **caractérisé par le fait que** ledit pointeur de fin (4) est mis dans une position spécifique pendant la phase d'initialisation dudit appareil (5), selon une règle de positionnement prédéterminée.

6. Procédé selon la revendication 2, **caractérisé par le fait que** ledit pointeur de fin (4) se déplace le long de ladite mémoire tampon de transaction (1), après une transaction de début de ladite transaction sécurisée, en réinitialisant son adresse en un endroit aléatoire compris entre :
- l'adresse de début de ladite mémoire tampon de transaction (1), et
- l'endroit obtenu en ajoutant à ladite adresse de début la différence entre les longueurs de ladite mémoire tampon de transaction (1) et de ladite pile de transaction (2).

7. Procédé selon la revendication 2, **caractérisé par le fait que** ladite pile de transaction (2) se déplace de manière cyclique le long de ladite mémoire tampon de transaction (1) par un réglage dudit pointeur de fin (4) dans différentes positions le long de la mémoire tampon de transaction (1) après chaque transaction de début et en réinitialisant ledit pointeur de fin (4) au début de ladite mémoire tampon de transaction (1) de manière cyclique.

8. Appareil électronique comprenant une partie mémoire non volatile à cycle d'écriture limité (5) et dans lequel les données non volatiles sont stockées pendant des transactions sécurisées, **caractérisé par** une pile de transaction (2) qui glisse de façon dynamique à l'intérieur d'une mémoire tampon de transaction (1) de ladite partie mémoire non volatile après l'exécution d'une dite transaction sécurisée, ladite pile de transaction (2) ayant une plus petite taille que ladite mémoire tampon de transaction (1), ladite pile de transaction (2), après l'exécution d'une dite transaction sécurisée, chevauchant partiellement la pile de transaction avant ladite exécution d'une dite transaction sécurisée.
